# FASCICULE DE BREVET EUROPEEN

(11) **EP 2 166 563 B1**
(45) Date de publication et mention de la délivrance du brevet: **23.12.2015**
(21) Numéro de dépôt: 09170352.0
(22) Date de dépôt: 15.09.2009
(51) Int. Cl.: H01L 21/20, H01L 21/321, H01L 21/02, H01L 29/786, H01L 29/10

(54) **Procédé de fabrication d'un dispositif microélectronique doté de zones semi-conductrices sur isolant à gradient horizontal de concentration en Ge**
Herstellungsverfahren einer mikroelektronischen Vorrichtung, die mit Halbleiterzonen auf einem Isolator mit horizontalem Gradienten der Germaniumkonzentration ausgestattet ist
Method for manufacturing a microelectronic device equipped with semiconductor areas on an insulator with horizontal Ge concentration gradient

(30) Priorité: 18.09.2008 FR 0856303
(43) Date de publication de la demande: 24.03.2010
(73) Titulaire: Commissariat à l'Énergie Atomique et aux Énergies Alternatives, 75015 Paris (FR)
(72) Inventeur: Vincent, Benjamin, 1050 Ixelles (BE); Destefanis, Vincent, 38120 Saint Egreve (FR)
(74) Mandataire: Ilgart, Jean-Christophe

(56) Documents cités:
- US-A1- 2007 108 481
- US-A1- 2007 284 625
- HIROYUKI HIRAYAMA ET AL: "{311} FACETS OF SELECTIVELY GROWN EPITAXIAL SI LAYERS ON SIO2-PATTERNED SI(100) SURFACES" PHYSICAL REVIEW, B. CONDENSED MATTER, AMERICAN INSTITUTE OF PHYSICS. NEW YORK, US, vol. 48, no. 23, 15 décembre 1993 (1993-12-15), pages 17331-17337, XP000425759 ISSN: 0163-1829
- VINCENT B ET AL: "Fabrication of SiGe-on-insulator substrates by a condensation technique: an experimental and modelling study; Fabrication of SiGe-on-insulator substrates by a condensation technique" SEMICONDUCTOR SCIENCE AND TECHNOLOGY, IOP, BRISTOL, GB, vol. 22, no. 3, 1 mars 2007 (2007-03-01), pages 237-244, XP020114949 ISSN: 0268-1242

## Description

### DOMAINE TECHNIQUE

L'invention concerne le domaine de la microélectronique, et plus particulièrement la réalisation d'un dispositif microélectronique doté de zones semi-conductrices comportant un gradient horizontal de concentration en Ge.

Elle prévoit également un procédé amélioré de réalisation de surfaces localement désorientées à partir de telles zones semi-conductrices.

### ÉTAT DE LA TECHNIQUE ANTÉRIEURE

Il est intéressant de doter les dispositifs microélectroniques de zones semi-conductrices à base de Si_{1-b}Ge_{b} dans la mesure où, d'une part ce matériau comporte de bonnes propriétés de transport de porteurs de charges, en particulier une meilleure mobilité des porteurs de charge que le silicium, d'autre part ce matériau comporte de bonnes propriétés mécaniques, et peut être utilisé pour exercer une contrainte mécanique sur des couches environnantes, par exemple à base de Si.

Il est connu de réaliser des zones semi-conductrices à base de Si_{1-b}Ge_{b} enrichies en Germanium à l'aide d'un procédé dit de condensation Germanium dans lequel on réalise une oxydation thermique de zones à base de Si₁₋ₐGeₐ. Un tel procédé est décrit par exemple dans le document de Tezuka et al. : "A *novel fabrication technique of ultrathin and relaxed SiGe Buffer layers with high Ge fraction for sub-100 nm strained Silicon on Insulator MOSFETs".*

Dans ce document, un procédé de réalisation de zones à base de SiGe comportant un gradient de concentration vertical en Ge est divulgué.

Un autre exemple d'un procédé de réalisation d'un dispositif comportant un gradient horizontal de concentration en Germanium est décrit dans US 2007/0284625 A1.

La formation de couches appelées « substrats virtuels » obtenues par croissance par épitaxie à l'aide de gaz précurseurs de Ge et de Si, en faisant varier la proportion de ces gaz lors de la croissance, est connue. Cela permet également d'obtenir des zones semi-conductrices à base de Si_{1-b}Ge_{b} ayant un gradient de concentration en Ge.

La réalisation de zones à base de Si₁₋ₐGeₐ et à gradient horizontal de concentration en Ge est connue, et a été divulguée par exemple dans le document : « Laterally graded SiGe crystals for high resolution synchrotron Optics » A. Erko, N.V. Abrosimov and V. Alex, Cryst. Res. Technol. 37(2002)7 685. Un tel procédé comprend une croissance de cristaux de SiGe contenant un gradient de SiGe. Un tel procédé présente pour inconvénients d'être difficile à mettre en oeuvre, coûteux, d'engendrer une défectuosité cristalline importante, et de ne pas être bien adapté à des substrats de diamètre supérieur à 200 mm.

Il se pose le problème de trouver un nouveau procédé microélectronique de réalisation sur un substrat d'une ou plusieurs zones semi-conductrices à gradient de concentration en Ge.

### EXPOSÉ DE L'INVENTION

L'invention concerne un procédé de fabrication de zones semi-conductrices à base d'un alliage Si_{1-z}Ge_{z} sur isolant et présentant un gradient horizontal de concentration z en Ge.

Au sein de cet alliage, z peut varier latéralement de 0 à 1.

Le procédé comprend les étapes de :
a) formation sur un support d'au moins un masquage à oxydation comprenant un ou plusieurs trous les trous dévoilant au moins une première zone semi-conductrice qui est à base de Si et comporte des flancs inclinés et étant dotée d'une portion centrale et d'une portion périphérique d'épaisseur inférieure à celle de ladite portion centrale,
b) formation d'au moins une deuxième zone semi-conductrice à base de Si₁₋ₓGeₓ (avec 0 < x) sur ladite première zone semi-conductrice à base de Si de manière à dépasser de l'embouchure des trous, polissage de la deuxième zone semi-conductrice jusqu'au niveau de la couche de masquage puis,
c) oxydation thermique à travers ledit masquage de ladite première zone semi-conductrice et de ladite deuxième zone semi-conductrice.

Le gradient de concentration en Ge formé peut être tel qu'il augmente du centre de la zone semi-conductrice vers sa périphérie.

La première zone semi-conductrice et la deuxième zone semi-conductrices empilées peuvent former un bloc dans lequel un ratio entre épaisseur de Si₁₋ₓGeₓ et épaisseur de Si augmente du centre du bloc vers la périphérie du bloc.

La première zone semi-conductrice à base de Si peut comporter des flancs inclinés orientés selon {11n}.

Le support peut être un substrat semi-conducteur sur isolant, en particulier un substrat SOI, comprenant une couche de support, une couche isolante reposant sur ladite couche de support, et une fine couche semi-conductrice reposant sur ladite couche isolante.

Le masquage à oxydation peut être prévu avec une épaisseur Emasque supérieure à l'épaisseur Esi de la première zone semi-conductrice.

La première zone semi-conductrice peut être une couche à base de Si formée par croissance sur la fine couche semi-conductrice qui peut être également à base de Si.

Selon une possibilité, l'étape a) peut comprendre :
- la formation d'une ou plusieurs ouvertures dans la fine couche semi-conductrice et dévoilant ladite couche isolante du substrat,
- la formation d'un masquage comblant lesdites ouvertures,
- la croissance sur la fine couche semi-conductrice de ladite première zone semi-conductrice.

Selon une mise en oeuvre possible du procédé, ce dernier peut comprendre en outre, entre l'étape b) et l'étape c) : le retrait d'une épaisseur de la deuxième zone semi-conductrice et du masquage de manière à dévoiler la première zone semi-conductrice.

Le procédé peut comprendre après l'étape c), le retrait dudit masquage et d'au moins une couche de SiO₂ formée lors de l'oxydation.

Selon une possibilité de mise en oeuvre, la deuxième zone semi-conductrice à base de Si₁₋ₓGeₓ peut avoir une concentration en Ge comprise entre 5 et 40 %.

L'invention concerne également un procédé de réalisation d'au moins une zone localement désorientée sur une ou plusieurs desdits zones semi-conductrices présentant dans une direction parallèle au plan principal du support, un gradient de concentration en Germanium, et formées à l'aide d'un procédé tel que défini plus haut.

L'invention concerne également un procédé de réalisation d'au moins une hétérojonction formée d'au moins une zone donnée semi-conductrice présentant dans une direction parallèle au plan principal du support, un premier gradient de concentration en Germanium, et d'au moins une autre zone semi-conductrice accolée à ladite zone donnée et présentant dans une direction parallèle au plan principal du support, un deuxième gradient de concentration en Germanium, ladite zone donnée et ladite autre zone ayant été formées à l'aide d'un procédé tel que défini plus haut.

L'invention concerne également un procédé de réalisation d'au moins un transistor MOS à partir d'une ou plusieurs zones semi-conductrices présentant dans une direction parallèle au plan principal du support, un premier gradient de concentration en Germanium, formées à l'aide d'un procédé tel que défini plus haut.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1F illustrent un exemple de procédé suivant l'invention, de réalisation d'un dispositif microélectronique comprenant des zones semi-conductrices à base de Si_{1-z}Ge_{z} présentant horizontalement un gradient de concentration en Ge et qui sont situées de part et d'autre d'une zone semi-conductrice à base de Si,
- les figures 2A-2B illustrent un dispositif microélectronique, respectivement avant et après une étape de condensation germanium par oxydation, au cours d'un procédé de réalisation suivant l'invention,
- les figures 3A-3B : illustrent un procédé de réalisation d'une structure SGOI comportant une zone semi-conductrice à base de Si_{1-z}Ge_{z} avec gradient de concentration en Ge horizontal, et comportant une zone centrale à base de SiGe et une zone périphérique à base de Ge ou fortement enrichie en Ge,

- les figures 4A-4B illustrent une procédé de réalisation d'une structure SGOI comportant une zone semi-conductrice à base de Si_{1-z}Ge_{z} avec gradient de concentration en Ge horizontal, et comportant une zone centrale à base de Si et une zone périphérique à base de Ge ou fortement enrichie en Ge,
- les figures 5A-5B : illustrent un exemple de réalisation de surfaces localement désorientées ou facettes à partir d'une structure comportant une zone semi-conductrice à base de Si_{1-z}Ge_{z} avec gradient de concentration en Ge horizontal, obtenue à l'aide d'un procédé suivant l'invention,
- les figures 6A-6D et 7A-7D : illustrent l'influence de la concentration en Ge dans des zones SiGe formées à l'aide d'étapes d'un procédé suivant l'invention, sur l'angle des surfaces localement désorientées réalisées à l'aide d'un procédé suivant l'invention,
- la figure 8 illustre un exemple de dispositif microélectronique suivant l'invention, doté d'une zone semi-conductrice contrainte reposant sur une zone semi-conductrice à base de Si_{1-z}Ge_{z} avec gradient de concentration en Ge horizontal,
- la figure 9 illustre un exemple de dispositif suivant l'invention, formé d'une jonction dotée d'une première zone semi-conductrice contrainte reposant une zone semi-conductrice à base de Si_{1-z1}Ge_{z1} avec gradient de concentration en Ge horizontal, accolée à une deuxième zone semi-conductrice contrainte reposant sur une zone semi-conductrice à base de Si_{1-z2}Ge_{z2} avec gradient de concentration en Ge horizontal,
- la figure 10 illustre une variante d'étape du procédé suivant l'invention, permettant de favoriser la formation de zones semi-conductrices dotées de flancs inclinés,
- les figures 11A, 11B illustrent respectivement une surface de Si qui n'est pas désorientée et une surface de Si désorientée.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

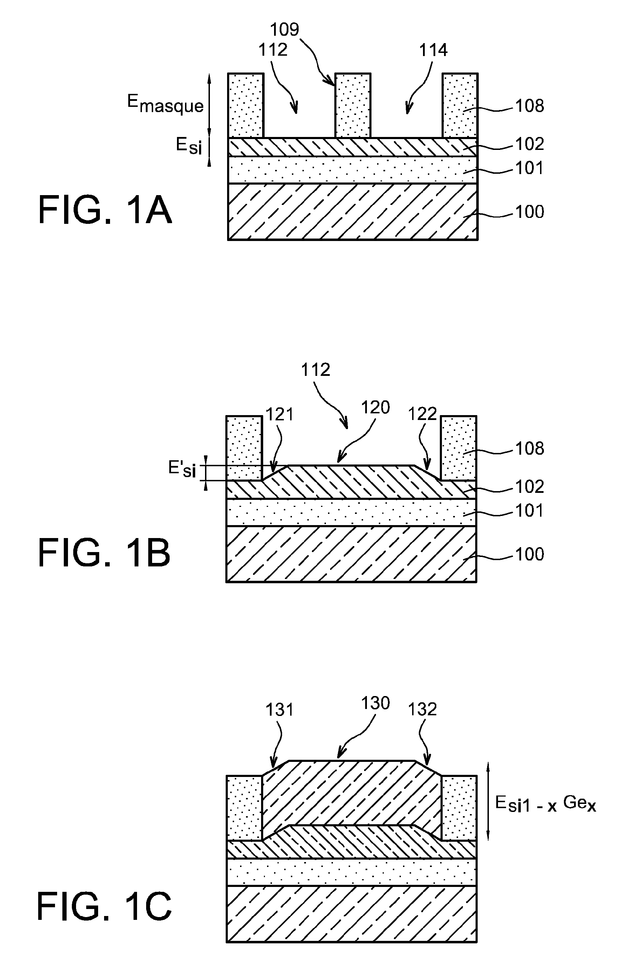

Un exemple de procédé, suivant l'invention, de réalisation d'un dispositif microélectronique doté d'une ou plusieurs zones semi-conductrices à base de Si_{1-z}Ge_{z} (avec 0 < z ≤ 1) reposant sur un substrat et présentant dans une direction horizontale, c'est-à-dire parallèle au substrat, un gradient de concentration en Ge, va à présent être donné en liaison avec les figures 1A à 1F.

Le matériau de départ du procédé est un substrat de type semi-conducteur sur isolant, par exemple de type SOI (SOI pour « silicon on insulator » ou silicium sur isolant) comprenant une couche de support 100 par exemple à base de Si, recouverte d'une couche de matériau diélectrique 101 par exemple une couche d'oxyde de silicium SiO₂ enterré (« burried oxyde » selon la terminologie anglo-saxonne) elle-même recouverte d'une fine couche semi-conductrice 102 par exemple à base de Si, et d'épaisseur Eₛᵢ comprise par exemple entre 5 et 50 nanomètres ou par exemple de l'ordre de 10 nanomètres.

Un masquage à oxydation est ensuite réalisé sur la couche semi-conductrice 102 à base de Si. Le masquage peut être formé d'au moins une couche 108 qui peut être à base d'un matériau diélectrique tel que, par exemple, du SiₓN_{y}, en particulier du Si₃N₄, ou éventuellement d'un empilement de plusieurs couches de matériau (x) diélectrique(s).

La couche 108 de masquage peut être réalisée par dépôt et peut avoir une épaisseur E_{masque} par exemple de l'ordre de 100 nanomètres ou de plusieurs centaines de nanomètres, ou comprise par exemple entre 10 et 500 nanomètres.

Ensuite, on réalise des trous 112, 114, dans la couche 108 de matériau diélectrique. Les trous 112, 114, sont formés de manière à dévoiler la couche 102 à base de Si. Les trous 112, 114, peuvent être réalisés par exemple par un procédé comprenant au moins une étape de photolithographie ou de lithographie par faisceau d'électrons (figure 1A).

Ensuite, on forme sur la couche semi-conductrice 102, des zones 120 semi-conductrices à base de Si, dans les trous 112, 114.

Ces zones 120 à base de Si peuvent être formées par croissance par épitaxie localisée de Si sur la couche semi-conductrice 102. L'épaisseur E'_{Si} des zones 120 à base de Si est prévue inférieure à celle E_{masque} des masques telle que E'_{Si} < E_{masque}.

L'épaisseur E'_{Si} des zones 120 à base de Si est inférieure à l'épaisseur Emasque, par exemple de l'ordre de 50 nanomètres.

Les zones 120 à base de Si sont formées avec des flancs inclinés qui peuvent être orientées selon {11n} avec n ≥ 1, par exemple n=1 ou n=3. Les zones 120 peuvent avoir des flancs 121, 122 inclinés qui peuvent s'étendre sur plusieurs dizaines de nanomètres ou plusieurs centaines de nanomètres (figure 1B).

Les flancs des zones 120 sont obtenus par épitaxie localisée, réalisée à basse pression, par exemple entre 1 Torr et plusieurs dizaines de Torr, et à haute température, par exemple à température supérieure à 750 °C.

L'angle θ entre les flancs 109 du masquage 108 et le plan de croissance peut être prévu supérieur à 80°, par exemple de l'ordre de 120° afin de favoriser la formation de flancs.

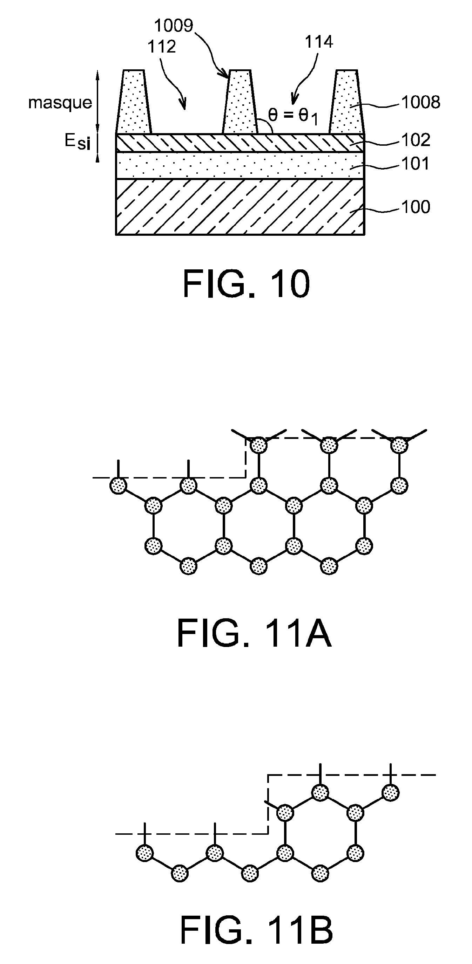

Sur la figure 10 un angle θ = θ1, avec θ1 > 90° est prévu entre les flancs 1009 d'un masquage 1008 afin de favoriser la formation de zones semi-conductrices 120 dotées de flancs inclinés.

Un contrôle de l'angle entre les flancs du masquage 1008 et le plan de croissance, basé sur une gravure plasma sélective, par exemple entre du SiO₂ (lorsque le masquage est à base de SiO₂) et le Si de la couche 102, peut être mis en oeuvre. Cette sélectivité repose notamment sur la proportion d'oxygène présent dans un mélange gazeux par exemple à base de Cl₂ - HBr - He - O₂ - CF₄. En augmentant la proportion d'oxygène dans le mélange gazeux, on peut obtenir un angle supérieur à 80° entre les flancs du masquage et le plan de croissance. Un autre facteur de contrôle de cet angle entre les flancs du masquage et le plan de croissance peut être la polarisation appliquée entre le plasma de gravure et le substrat 100.

Puis, on forme sur les zones **120** semi-conductrices, d'autres zones semi-conductrices 130 à base de Si₁₋ₓGeₓ (avec x > 0) par croissance par épitaxie localisée de Si₁₋ₓGeₓ sur les zones semi-conductrices 120 à base de Si.

L'épaisseur E_{Si1-xGex} des zones 130 à base de Si₁₋ₓGeₓ est prévue de sorte que ces zones 130 dépassent de l'embouchure des trous 112, 114.

La croissance par épitaxie peut être telle qu'elle conduit à la formation de zones 130 d'épaisseur conforme, c'est-à-dire d'épaisseur constante, la forme des zones 130 reproduisant celle des zones 120. Les zones 130 à base de Si₁₋ₓGeₓ peuvent éventuellement comporter des facettes ou des flancs 131, 132 incliné(e)s suivant les plans {311}, ou les plans {311} et {111}. Les zones 130 à base de Si₁₋ₓGeₓ peuvent être éventuellement formées avec une épaisseur E_{Si1-x}Geₓ importante, de sorte qu'elles ne présentent pas de profil avec des flancs inclinés.

Dans un exemple qui ne fait pas partie de l'invention, les zones 130 à base de Si₁₋ₓGeₓ peuvent être prévues avec une épaisseur E_{Si1-xGex} de l'ordre de celle, ou égale à celle E_{masque} du masquage à oxydation. L'épaisseur E_{Si1-xGex} peut être choisie inférieure à l'épaisseur de relaxation plastique de l'alliage Si₁₋ₓGeₓ. L'alliage Si₁₋ₓGeₓ peut être choisi de manière à avoir une faible concentration en Ge, par exemple telle que x est compris entre 5 et 40 %, par exemple à une concentration en Ge de l'ordre de 30 % (figure 1C).

Pour une concentration en Ge de l'ordre de 30 %, l'épaisseur de relaxation plastique peut être de l'ordre de 40 nm.

Les zones 130 à base de E_{Si1-x}Geₓ peuvent être éventuellement réalisées dans un même équipement que celui dans lequel les zones 120 à base de Si sont formées.

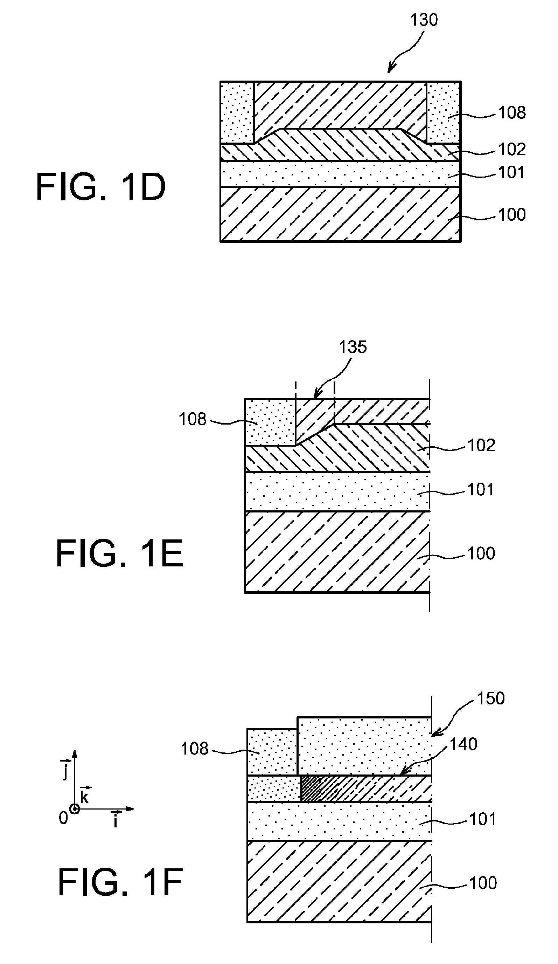

Un polissage mécano-chimique (CMP pour « Chemical Mechanical Planarization ») du matériau semi-conducteur des zones 130 dépassant de la face supérieure de la couche 108 est ensuite effectué. Le polissage est réalisé avec un arrêt sur la couche 108 de masquage à oxydation, afin de réduire l'épaisseur des zones semi-conductrices 130, et d'obtenir une épaisseur cumulée E_{Si} + E_{Si1-xGex} des zones semi-conductrices 120 et 130 empilées égale ou sensiblement égale à celle de la couche 108 du masque à oxydation, de sorte que E_{Si} + E_{Si1-xGex} ≈ E_{masque} (figure 1D).

Dans chacun des trous 112, 114, un bloc semi-conducteur formé d'un empilement d'une zone à base d'un alliage Si₁₋ₓGeₓ sur une zone de Si avec un ratio (épaisseur de Si₁₋ₓGeₓ/épaisseur de Si) variable, et en particulier un ratio (quantité de Ge/quantité de Si) augmentant du centre du bloc vers les bords ou la périphérie du bloc est obtenu.

La zone 135 sur laquelle le ratio (E_{SiGe}/E_{Si}) croît correspond à un endroit où la zone 120 de Si présente des flancs inclinés. Cette zone 135 peut avoir une longueur comprise entre plusieurs dizaines et plusieurs centaines de nanomètres (figure 1E).

Puis (figure 1F), on effectue une étape de condensation localisée du Ge des zones semi-conductrices 130 à base de Si₁₋ₓGeₓ, par exemple à l'aide d'un procédé d'oxydation sélective du Si, par exemple une oxydation sèche à haute température, par exemple supérieure à 900 °C.

La condensation peut être réalisée à l'aide d'un procédé de condensation tel que celui décrit dans le document : *« A novel fabrication technique of ultrathin and relaxed SiGe buffer layers with high Ge fraction for sub-100 nm strained silicon on insulator MOSFETs,* Tezuka et al., Japaneese Journal of Applied Physics, vol. 40, p 2866-2874, 2001 *».*

Pour effectuer cette condensation de Ge, au moins une étape d'oxydation thermique des zones semi-conductrices 130 à base de Si₁₋ₓGeₓ est réalisée à haute température, et à travers le masquage à oxydation formé dans la couche 108. La température d'oxydation est de préférence inférieure à la température de fusion du matériau Si₁₋ₓGeₓ de la zone semi-conductrice 130. Les éléments masquant ou blocs de masquage de la couche 108, peuvent permettre de retarder ou d'empêcher l'oxydation de la couche semi-conductrice 102. Il est éventuellement possible de bloquer totalement l'oxydation.

Une fois l'étape d'oxydation terminée, on obtient des zones 140 à base de Si_{1-z}Ge_{z} (avec z > x) de compositions en Germanium ou de teneur en Germanium variable dans une direction horizontale. Les zones 140 à base de Si_{1-z}Ge_{z} suivent un gradient de concentration en Ge dans une direction parallèle au support 100 ou au plan principal du support, (le plan principal du support étant défini par un plan passant par le support 100 et parallèle au plan [O*;i̅;k̅*] du repère orthogonal [O*;i̅;j̅;k̅*] sur la figure 1F).

Dans les zones semi-conductrices 140, la teneur en Germanium varie et augmente du centre 140a des zones 140 vers la périphérie 140b de ces zones 140, à proximité d'une interface avec la fine couche semi-conductrice 102.

Les zones semi-conductrices 140 sont à base de Si_{z1}Ge_{1-z1} en leur centre 140a et à base de Si_{z2}Ge_{1-z2} au niveau de leur périphérie 140b, avec z2 < Z1 et z2 qui peut être proche de ou sensiblement égal à 0.

Ainsi, selon une possibilité, les zones semi-conductrices 140 peuvent être à base de Ge ou fortement enrichies en Ge au niveau de leurs extrémités 140b, à proximité du masque à oxydation.

Une fois l'étape d'oxydation terminée, les zones 140 à base de Si_{1-z}Ge_{z} sont surmontées d'une couche 150 à base de SiO₂ formée lors de l'oxydation. Le masque à oxydation, et en particulier l'épaisseur et la composition de ce masque sont prévues de sorte que la couche semi-conductrice 102 recouverte par ce masque est laissée intacte (figure 1F).

La couche 150 de SiO₂ formée lors de l'oxydation ainsi que la couche 108 du masque à oxydation sont ensuite retirées.

La couche 150 de SiO₂ peut être retirée par exemple à l'aide d'une gravure humide à l'aide de HF, tandis que la couche 108 peut, lorsqu'elle est à base de SiₓN_{y}, être retirée par exemple à l'aide de H₃PO₄.

Dans le procédé de condensation qui est mis en oeuvre, le Germanium est conservé, de sorte que l'enrichissement final en Ge des zones semi-conductrices 140 à base de Si_{1-z}Ge_{z} dépend du ratio initial entre la quantité de Ge et la quantité de Si des zones semi-conductrices 120. Suite au procédé de condensation, le taux de variation de concentration en Ge des zones semi-conductrices situées dans les trous 112, 114, est croissant du centre vers les extrémités des zones 140 de SGOI (SGOI pour « Silicon Germanium on Insulator » ou SiGe sur isolant). Un gradient de concentration en Ge dans une direction horizontale est donc finalement obtenu.

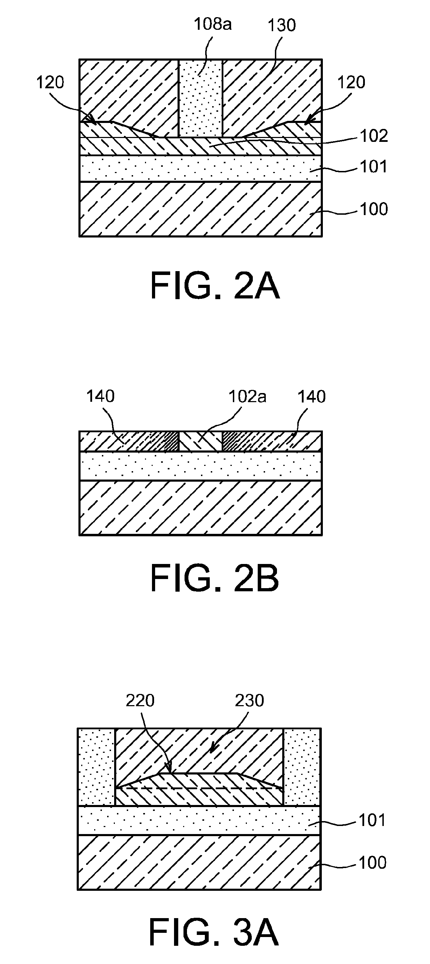

Sur la figure 2A, une autre partie du dispositif formé à l'étape 1D est représentée, au niveau d'un bloc 108a de la couche 108 de masquage à oxydation formé sur la fine couche semi-conductrice 102. De part et d'autre de ce bloc 108a, des zones semi-conductrices 120 à base de Si comportant des flancs 121 inclinés sont recouvertes chacune par une zone 130 de Si₁₋ₓGeₓ.

Sur la figure 2B, cette autre partie du dispositif est représentée, une fois que l'étape de condensation Germanium a été réalisée et que le masquage à oxydation et la couche de SiO₂ crée par oxydation lors du procédé de condensation Ge, ont été retirées.

A l'endroit où se trouvait le bloc 108a de la couche 108 de masquage à oxydation, se trouve une zone 102a à base de Si, qui est issue de la fine couche 102 semi-conductrice. De part et d'autre de cette zone 102a à base de Si, reposent des zones semi-conductrices 140 à base de Si_{1-z}Ge_{z} (avec z > y), qui présentent un gradient de concentration en Ge dans une direction horizontale, parallèle au plan principal du support 100.

De telles zones peuvent permettre de réaliser un dispositif microélectronique tel qu'un transistor comportant des contraintes mécaniques, tout en conservant une continuité de paramètre de maille, et minimisant ainsi la présence de défauts.

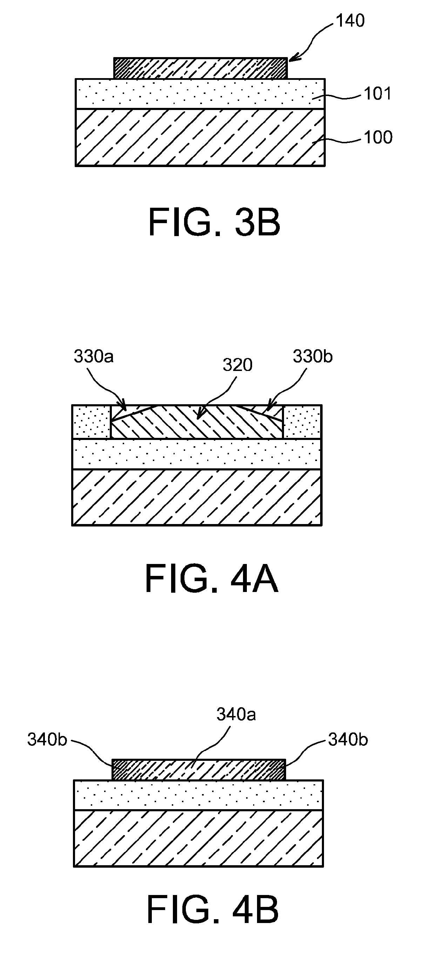

Un autre exemple de procédé de réalisation est donné sur les figures 3A et 3B.

Pour cette variante, le matériau de départ peut être un substrat SOI tel que décrit précédemment, dont on retire à un ou plusieurs endroits, la fine couche semi-conductrice 102, par exemple à l'aide d'un procédé comportant au moins une étape de photolithographie, puis de gravure de silicium.

Un masque 208 à oxydation est ensuite réalisé aux endroits où la couche semi-conductrice 102 a été retirée, et repose ainsi sur la couche 101 de SiO₂ du substrat.

Le masquage 208 à oxydation comporte des ouvertures dans lesquelles on forme sur la fine couche semi-conductrice 102, une zone semi-conductrice 220 à base de Si, qui comporte des flancs inclinés et une zone semi-conductrice 230 à base de Si₁₋ₓGeₓ (avec x > 0) reposant sur la zone 220 à base de Si (figure 3A).

Les zones semi-conductrices 220 et 230 peuvent être formées successivement par croissance par épitaxie en partant d'une portion de la fine couche semi-conductrice 102 qui n'a pas été gravée.

Une étape d'oxydation des zones 220, 230, est réalisée à haute température, à travers le masquage 208. L'étape d'oxydation consomme le silicium de la fine couche semi-conductrice 102, des zones semi-conductrices 220 et 230, respectivement à base de Si et à base de Si₁₋ₓGeₓ.

Le masquage 208 peut avoir une épaisseur par exemple de l'ordre de 100 nanomètres ou de plusieurs centaines de nanomètres, ou comprise par exemple entre 10 et 500 nanomètres.

L'épaisseur des zones 220, 230 est inférieure à l'épaisseur du masque 208, par exemple de l'ordre de 50 nanomètres.

Une fois l'étape d'oxydation terminée, le masquage 208 ainsi qu'une couche de SiO₂ résultant de cette oxydation retirées, on obtient au moins une zone 240, à base de Si_{1-z}Ge_{z} (avec z > 0) comportant un gradient de concentration dans une direction horizontale et reposant directement sur la couche isolante 101 du substrat.

Selon une variante (figures 4A et 4B) de l'exemple de procédé de réalisation qui vient d'être décrit, et qui ne fait pas partie de l'invention, on forme sur la couche 101 d'oxyde enterré, un masquage 208 à oxydation à base par exemple de Si₃N₄ et comportant des ouvertures dans lesquelles sont formés des blocs semi-conducteurs, de même hauteur ou sensiblement de même hauteur que celle du masquage 208.

Les blocs semi-conducteurs peuvent être formés d'une zone 320 à base de Si comportant des facettes recouvertes de zones 330a, 330b, à base de Si₁₋ₓGeₓ, les zones 330a et 330b ayant un agencement prévu de sorte que lesdits blocs sont planes.

Les blocs semi-conducteurs peuvent avoir été formés à l'aide d'au moins une étape de polissage mécano-chimique (CMP), par exemple par une étape de polissage d'un dispositif tel que décrit précédemment en liaison avec la figure 3A de la zone semi-conductrice 240, conduisant à un retrait d'une épaisseur donnée du masque 208 à oxydation et d'une épaisseur de la zone semi-conductrice 240, égale ou sensiblement égale à l'épaisseur donnée, et permettant de dévoiler la face supérieure de la zone 320 (figure 4A).

Une étape de condensation germanium par oxydation du bloc semi-conducteur est ensuite réalisée, à travers le masquage 208 à oxydation. L'étape d'oxydation est réalisée de sorte que le silicium des zones semi-conductrices 330a et 330b à base de Si₁₋ₓGeₓ est consommé.

Une fois l'étape d'oxydation terminée, le masquage 208, ainsi qu'une couche de SiO₂ résultante de l'oxydation du Si lors du procédé de condensation germanium, sont retirées.

On obtient alors au moins une zone 340 semi-conductrice comportant un gradient de concentration en Ge dans une direction horizontale, c'est-à-dire parallèle au support 100, et reposant directement sur la couche isolante 101. Au centre 340a de la zone semi-conductrice, cette dernière est formée de Si, issu de la zone semi-conductrice 230 et de la fine couche semi-conductrice 102.

Les extrémités 340a, 340b de la zone semi-conductrice 340 sont à base de Si_{1-w}Ge_{w} (avec w > y), et résultent de l'oxydation des zones semi-conductrices 330a, 330b à base de Si_{1-y}Ge_{y} d'épaisseur variable, et présentent un gradient de concentration en Ge, la concentration en Ge augmentant dans des directions centripètes de la zone semi-conductrice 350 et parallèles au support 100 (figure 4B).

Une structure comprenant une ou plusieurs zones de SiGe sur isolant (SGOI) à gradient de concentration en Ge telles que décrites précédemment, peut être utilisée pour fabriquer des zones semi-conductrices localement désorientées.

Des surfaces localement désorientées peuvent être obtenues par Epitaxie localisée. A partir des zones de SiGe obtenues précédemment, par gravure ou oxydation ayant une cinétique dépendante d'une concentration en Ge, des surfaces localement désorientées peuvent être obtenues.

Les surfaces obtenues sont de type {11n} avec n pouvant valoir plusieurs dizaines.

Des zones localement désorientées peuvent être utilisées comme support de croissance à des zones semi-conductrices III-V. Cela peut permettre d'obtenir des zones semi-conductrices III-V tout en produisant une quantité faible de défauts.

De tels défauts, principalement des joints d'antiphase, sont générés lorsque les liaisons pendantes de Si ne sont pas dans la même direction (figure 11A).

L'utilisation de surfaces faiblement désorientées permet d'obtenir des surfaces ayant une majorité des liaisons pendantes du Si dans la même direction. On diminue ainsi sensiblement la génération du type de défaut précité (figure 11B).

Un des procédés décrits ci-dessus pour l'obtention d'une couche de SGOI à gradient horizontal de concentration en Ge suivi d'un procédé de gravure ou d'oxydation ayant une cinétique de consommation du Si₁₋ₓGeₓ dépendante de la concentration x en Ge, permet la mise en oeuvre de surfaces localement désorientées.

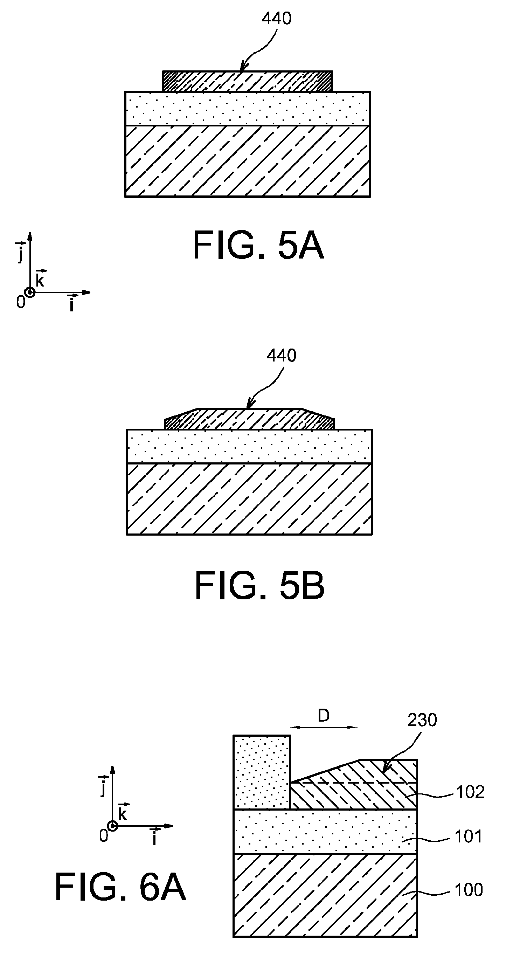

La réalisation de surfaces vicinales Sv peut être effectuée à partir d'une zone semi-conductrice 440 (figure 5A) à base de Si_{1-z}Ge_{z} et présentant un gradient de concentration en Ge dans une direction horizontale ou parallèle au plan principal de cette zone.

De telles surfaces peuvent être réalisées par gravure dont la cinétique dépend du pourcentage de Ge, en voie humide à l'aide par exemple de HF - HNO₃-CH₃COOH-HNA, ou par gravure plasma par exemple une gravure plasma CF₄ délocalisée. Le procédé de gravure permettant l'obtention de surfaces localement désorientées peut être un procédé de gravure chimique en phase vapeur ou CVE (CVE pour « Chemical Vapor Etching ») utilisant par exemple comme gaz de gravure l'acide chlorhydrique HCl mélangé à un gaz porteur, par exemple de l'hydrogène ou de l'azote. Cette gravure dont la cinétique est fonction du pourcentage de Ge des zones à gradient horizontale de Ge formées, peut être mis en oeuvre à une température qui peut être comprise entre 450°C et 900°C. La température de gravure peut être choisie inférieure ou égale à 700°C. A cette température, la gravure, en plus d'être sélective entre deux zones de SiGe à différentes concentrations de Ge, est extrêmement sélective vis-à-vis du silicium environnant, par exemple du silicium du substrat, la vitesse de gravure du silicium étant faible, c'est-à-dire au moins inférieure à 0,1 mn/min. La pression totale du mélange gazeux lors de la gravure est par exemple comprise entre 200 et 101 300 Pa. La pression partielle d'hydrogène peut être par exemple comprise entre 20 et 24 000 Pa. Le flux du mélange gazeux de gravure peut être compris par exemple entre plusieurs litres standard et plusieurs dizaines de litres standard par minute. Le flux d'HCl peut être compris entre plusieurs centaines de centimètres cube par minute et plusieurs dizaines de litres standard par minute. Le temps de gravure peut être compris entre plusieurs secondes et plusieurs centaines de secondes (figure 5B).

Selon une variante, les surfaces peuvent être réalisées par oxydation en voie humide.

Une surface désorientée peut être formée à l'aide de l'un ou l'autre des procédés qui viennent d'être donnés.

En adaptant la concentration zᵢ en Ge, de zones semi-conductrices à base de Si_{1-zi}Ge_{zi}, on peut ajuster l'angle d'une surface localement désorientée obtenue à partir d'une structure telle que décrite précédemment en liaison avec la figure 3B.

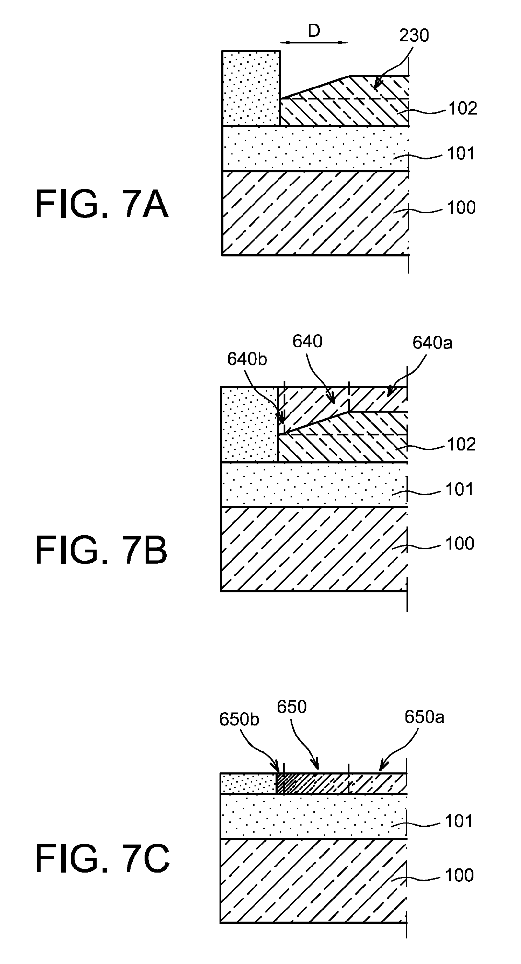

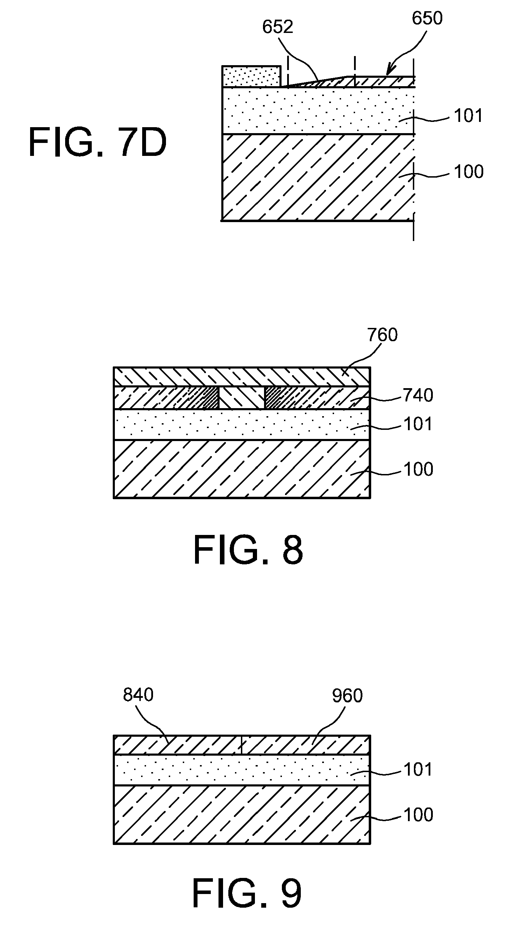

Les figures 6A-6D et 7A-7D donnent deux exemples de procédé réalisation de surfaces localement désorientées d'angles différents, à partir de zones semi-conductrices à base d'un alliage de Si et de Ge et ayant des teneurs en Ge différentes.

On peut utiliser comme matériau de départ un substrat SOI tel que décrit précédemment avec une fine couche 102 de Si supérieure, qui, dans cet exemple, est de l'ordre de 10 nm.

Par une épitaxie locale de Si, on forme une zone semi-conductrice 230, par exemple de l'ordre de 20 nm sur la fine couche semi-conductrice 102. La zone semi-conductrice 230 peut être telle que sur une distance D de l'ordre de 100 nm, à proximité du masquage 208 à oxydation, la couche de Si décroît de 30 à 10 nm depuis son centre, vers ses extrémités (figures 6A et 7A).

On réalise ensuite, dans un premier cas, une épitaxie de Si₁₋ₓ₁Geₓ₁ avec x1 = 0.1, afin de former une zone semi-conductrice 540 d'épaisseur de 40 nm à base de Si₁₋ₓ₁Geₓ₁.

Selon un deuxième cas, une épitaxie de Si₁₋ₓ₂Geₓ₂ est réalisée avec x2 = 0.2, afin de former une zone semi-conductrice 640 d'épaisseur de 40 nm à base de Si₁₋ₓ₂Geₓ₂.

L'épaisseur E_{masque} du masquage 208 à oxydation utilisé peut, quant à elle, être de l'ordre de 50 nm, de sorte que E_{masque} = E_{SiGe} + E_{Si}, (où E_{Si} l'épaisseur de la couche 102 et E_{SiGe} l'épaisseur des zones 540 et 640).

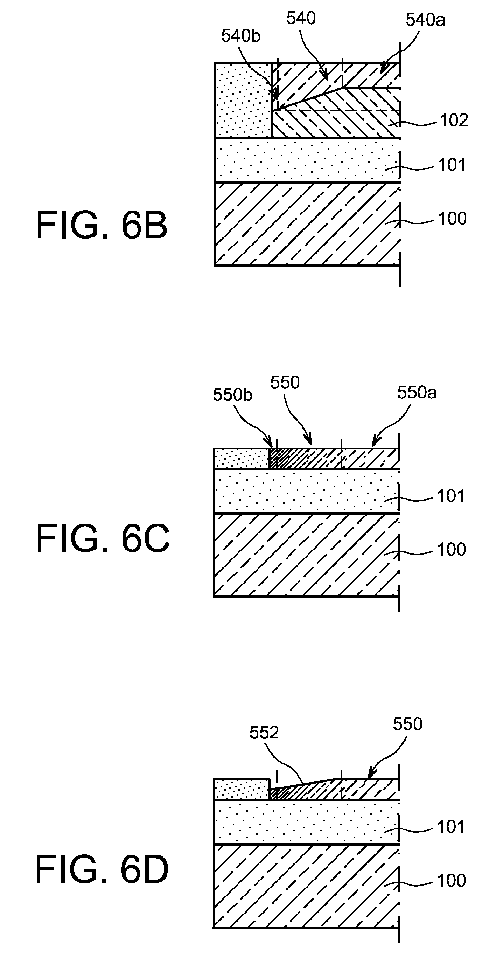

Dans le premier cas (figure 6B) après l'étape de polissage mécano-chimique, on peut obtenir une zone semi-conductrice 540, qui dans une région centrale 540a, peut avoir une épaisseur de 20 nm de Si_{0.9}Ge_{0.1} et reposer sur une épaisseur de 30 nm de Si, et dans une région périphérique 540b une épaisseur de 40 nm de Si_{0.9}Ge_{0.1} reposant sur une épaisseur de 10 nm.

Dans le deuxième cas (figure 7B) après l'étape de polissage mécano-chimique, on peut obtenir une zone semi-conductrice 640, qui dans une région centrale 640a, peut avoir une épaisseur de 20 nm de Si_{0.8}Ge_{0.2} et reposer sur une épaisseur de 30 nm de Si, et dans une région périphérique 640b une épaisseur de 40 nm de Si_{0.8}Ge_{0.2} reposant sur une épaisseur de 10 nm.

Une condensation de Ge par oxydation, est ensuite effectuée de manière à obtenir une zone semi-conductrice Si_{z}Ge_{1-z} d'épaisseur par exemple de l'ordre de 10 nanomètres.

Dans le premier cas, on peut obtenir une zone semi-conductrice 550, qui dans une région centrale 550a, peut être à base de Si_{0.8}Ge_{0.2} et dans une région périphérique 550b à base de Si_{0.6}Ge_{0.4} (figure 6C). Dans ce cas, la différence entre les deux concentrations extrêmes de Ge est de l'ordre de 20 % dans la zone semi-conductrice 550.

Dans le deuxième cas, on peut obtenir une zone semi-conductrice 650, qui dans une région centrale 650a, peut être à base de Si_{0.4}Ge_{0.4} et dans une région périphérique 650b à base de Si_{0.2}Ge_{0.8} (figure 7C). Dans ce cas, la différence entre les deux concentrations extrêmes de Ge est de l'ordre de 40 % dans la zone semi-conductrice 650.

Ainsi, sur une zone 550 ou 650 de l'ordre 100 nm de large, on peut obtenir selon le premier cas, un gradient Δ de l'ordre de 20 % et selon le deuxième cas, un gradient Δ de l'ordre 40%.

Ensuite, des surfaces localement désorientées sont formées, en appliquant un procédé de gravure ou d'oxydation tel que décrit précédemment, dont la cinétique de consommation du Si_{1-z}Ge_{z} dépend de la concentration z.

Les surfaces désorientées obtenues sont d'autant plus abruptes que le gradient en concentration est important. La zone semi-conductrice 550 obtenue dans le premier cas, peut comporter une région 552 réalisant un angle α avec le plan principal du substrat (définie sur la figure 6D comme un plan parallèle au plan [O; *i̅ ; k̅*] d'un repère orthogonal [O; *i̅; j̅; k̅*]) qui dépend du gradient de concentration en Ge dans la zone semi-conductrice 550. La zone semi-conductrice 550 obtenue dans le deuxième cas, peut avoir un angle β > α (l'angle β sur la figure 6D) qui dépend également du gradient de concentration en Ge dans la zone semi-conductrice 550.

A l'aide de l'un ou l'autre des exemples de procédés précédemment décrits, on peut mettre en oeuvre côte à côte, ou l'une sur l'autre, des zones à base d'alliages Si₁₋ₓGeₓ ayant différentes concentrations en Ge et présentant chacune un gradient horizontal de concentration.

A l'aide de l'un ou l'autre des exemples de procédés précédemment décrits, on peut également former au moins une zone semi-conductrice 760 contrainte, en particulier une zone 760 de Si contrainte et que l'on a formée, par exemple par croissance par épitaxie sur une zone 740 à base d'un alliage Si_{1-z}Ge_{z} présentant un gradient horizontal de concentration en Ge.

Un transistor MOS comportant des zones semi-conductrices à base d'un alliage Si_{1-z}Ge_{z} présentant un gradient horizontal de concentration en Ge, peut être mis en oeuvre dans les zones de source et de drain, les zones de SiGe enrichies étant de préférence situées à proximité du canal afin de contraindre ce dernier, tandis que les zones de SiGe à concentration en Ge plus faible sont situées aux extrémités des zones de sources et de drain pour faciliter les contacts.

Sur la figure 10, un dispositif microélectronique comprenant une hétérojonction nSi_{1-z1}Ge_{z1}-pSi_{1-z2}Ge_{z2} comportant une première zone semi-conductrice 840 à base de Si_{1-z2}Ge_{z2} ayant un premier gradient de concentration en Ge dans une direction horizontale, et une deuxième zone semi-conductrice 940 Si_{1-z2}Ge_{z2}, ayant un deuxième gradient de concentration en Ge dans la direction horizontale, est représentée. Les zones 840 et 940 reposent sur la couche isolante 101 d'un substrat et ont été formées à l'aide d'un procédé suivant l'invention.

## Revendications

1. Procédé de réalisation d'un dispositif microélectronique comportant au moins une zone semi-conductrice (140, 240, 340, 440, 550, 650, 740, 840, 940) reposant sur un support et présentant dans une direction parallèle au plan principal du support, un gradient de concentration en Germanium, la teneur en Ge augmentant du centre vers la périphérie de ladite zone semi-conductrice,
le procédé comprenant les étapes de :
a) formation sur un support d'au moins un masquage (108, 208 ) à oxydation comprenant un ou plusieurs trous (112, 114) les trous dévoilant au moins une première zone semi-conductrice à base de Si, la première zone semi-conductrice comportant des flancs inclinés (121, 122) et étant dotée d'une portion centrale et d'une portion périphérique d'épaisseur inférieure à celle de ladite portion centrale,
b) formation d'au moins une deuxième zone semi-conductrice (130, 230) à base de Si₁₋ₓGeₓ (avec 0 < x) sur ladite première zone semi-conductrice de manière à dépasser de l'embouchure des trous (112, 114),
- polissage de la deuxième zone semi-conductrice jusqu'au niveau de la couche de masquage (108, 208) puis,
c) oxydation thermique à travers ledit masquage de ladite première zone semi-conductrice et de ladite deuxième zone semi-conductrice.

2. Procédé selon la revendication 1, dans lequel ladite première zone semi-conductrice et ladite deuxième zone semi-conductrices empilées forment un bloc dans lequel un ratio entre épaisseur de Si₁₋ₓGeₓ et épaisseur de Si augmente du centre du bloc vers la périphérie du bloc.

3. Procédé selon la revendication 1 ou 2, dans lequel la première zone semiconductrice à base de Si comporte des flancs inclinés orientés selon {11n} (avec n≥1).

4. Procédé selon l'une des revendications 1 à 3, dans lequel le support est un substrat SOI comprenant une couche de support (100), une couche isolante (101) reposant sur la couche de support (100) et une fine couche semi-conductrice (102) reposant sur la couche isolante.

5. Procédé selon la revendication 4, dans lequel à l'étape a), la première zone semi-conductrice à base de Si est formée par croissance sur la fine couche (102) semi-conductrice.

6. Procédé selon la revendication 4, dans lequel l'étape a) comprend :
- la formation d'une ou plusieurs ouvertures dans la fine couche semi-conductrice,
- la formation d'un masquage comblant lesdites ouvertures,
- la croissance sur la fine couche (102) semi-conductrice de ladite première zone semi-conductrice.

7. Procédé selon l'une des revendications 1 à 6, le procédé comprenant en outre, entre l'étape b) et l'étape c) : le retrait d'une épaisseur de la deuxième zone semi-conductrice et du masquage de manière à dévoiler la première zone semi-conductrice.

8. Procédé selon l'une des revendications 1 à 9, comprenant après l'étape c), le retrait dudit masquage et d'au moins une couche de SiO₂ formée lors de l'oxydation.

9. Procédé selon l'une des revendications 1 à 8, dans lequel la deuxième zone semi-conductrice (130, 230) à base de Si₁₋ₓGeₓ a une concentration en Ge comprise entre 5 % et 40%.

10. Procédé de réalisation d'au moins une surface vicinales sur une ou plusieurs des dites zones semi-conductrices présentant dans une direction parallèle au plan principal du support, un gradient de concentration en Germanium, et formées à l'aide d'un procédé selon l'une des revendications 1 à 9.

11. Procédé de réalisation d'au moins une hétérojonction formée d'au moins une zone donnée semi-conductrice présentant dans une direction parallèle au plan principal du support, un premier gradient de concentration en Germanium, et d'au moins une autre zone semi-conductrice accolée à ladite zone donnée et présentant dans une direction parallèle au plan principal du support, un deuxième gradient de concentration en Germanium, ladite zone donnée et ladite autre zone ayant été formées à l'aide d'un procédé selon l'une des revendications 1 à 9.

12. Procédé de réalisation d'au moins un transistor MOS à partir d'une ou plusieurs zone semi-conductrices présentant dans une direction parallèle au plan principal du support, un premier gradient de concentration en Germanium, formées à l'aide d'un procédé selon l'une des revendications 1 à 9.

## Patentansprüche

1. Verfahren zur Herstellung einer mikroelektronischen Vorrichtung, umfassend wenigstens eine Halbleiterzone (140, 240, 340, 440, 550, 650, 740, 840, 940), die auf einem Träger ruht und in einer zur Hauptebene des Trägers parallelen Richtung einen Germaniumkonzentrationsgradienten aufweist, wobei der Gehalt an Ge von der Mitte zum Rand der Halbleiterzone zunimmt,
wobei das Verfahren die folgenden Schritte umfasst:
a) Bildung wenigstens einer Oxidationsmaskierung (108, 208) auf einem Träger, umfassend ein oder mehrere Löcher (112, 114), wobei die Löcher wenigstens einen ersten Halbleiterbereich auf der Basis von Si freilegen, wobei der erste Halbleiterbereich schräge Flanken (121, 122) aufweist und mit einem Mittelabschnitt und einem Randabschnitt versehen wird, dessen Dicke geringer ist als jene des Mittelabschnitts,
b) Bildung wenigstens eines zweiten Halbleiterbereichs (130, 230) auf der Basis von Si₁₋ₓGeₓ (mit 0 < x) auf dem ersten Halbleiterbereich, so dass sich dieser über die Einmündung der Löcher (112, 114) hinaus erstreckt, - Polieren des zweiten Halbleiterbereich bis auf die Ebene der Maskierungsschicht (108, 208), dann
c) thermische Oxidation durch die Maskierung des ersten Halbleiterbereichs und des zweiten Halbleiterbereichs hindurch.

2. Verfahren nach Anspruch 1, bei welchem der aufeinander gestapelte erste Halbleiterbereich und zweite Halbleiterbereich einen Block bilden, in welchem ein Verhältnis zwischen der Dicke von Si₁₋ₓGeₓ und der Dicke von Si von der Mitte des Blocks hin zum Rand des Blocks zunimmt.

3. Verfahren nach Anspruch 1 oder 2, bei welchem der erste Halbleiterbereich auf Si-Basis schräge Flanken aufweist, die gemäß {11n} (mit n≥1) ausgerichtet werden.

4. Verfahren nach einem der Ansprüche 1 bis 3, bei welchem der Träger ein SOl-Substrat ist, umfassend eine Trägerschicht (100), eine Isolierschicht (101), die auf der Trägerschicht(100) ruht und eine feine Halbleiterschicht (102), die auf der Isolierschicht ruht.

5. Verfahren nach Anspruch 4, bei welchem in Schritt a) der erste Halbleiterbereich auf Si-Basis durch Wachstum auf der feinen Halbleiterschicht (102) gebildet wird.

6. Verfahren nach Anspruch 4, bei welchem der Schritt a) umfasst:
- die Bildung einer oder mehrerer Öffnungen in der feinen Halbleiterschicht,
- die Bildung einer Maskierung, die die Öffnungen füllt,
- das Wachstum des ersten Halbleiterbereichs auf der feinen Halbleiterschicht (102).

7. Verfahren nach einem der Ansprüche 1 bis 6, wobei das Verfahren unter anderem zwischen Schritt b) und Schritt c) umfasst: den Rückgang einer Dicke des zweiten Halbleiterbereichs und der Maskierung, so dass der erste Halbleiterbereich freilegt wird.

8. Verfahren nach einem der Ansprüche 1 bis 7, welches nach Schritt c) den Rückgang der Maskierung und wenigstens einer bei der Oxidation gebildeten SiO₂-Schicht umfasst.

9. Verfahren nach einem der Ansprüche 1 bis 8, bei welchem der zweite Halbleiterbereich (130, 230) auf Si₁₋ₓGeₓ-Basis eine Ge-Konzentration von zwischen 5% und 40% aufweist.

10. Verfahren zur Herstellung wenigstens einer Nachbarschicht auf einem oder mehreren der Halbleiterbereiche, umfassend einen Germaniumkonzentrationsgradienten in einer zur Hauptebene des Trägers parallelen Richtung und mittels eines Verfahrens nach einem der Ansprüche 1 bis 9 gebildet.

11. Verfahren zur Herstellung wenigstens eines Heteroübergangs, der aus wenigstens einem gegebenen Halbleiterbereich gebildet ist, welcher in einer zur Hauptebene des Trägers parallelen Richtung einen ersten Germaniumkonzentrationsgradienten aufweist, und aus wenigstens einem anderen Halbleiterbereich, der an den gegebenen Bereich angrenzt, mit einem zweiten Germaniumkonzentrationsgradienten in einer zur Hauptebene des Trägers parallelen Richtung, wobei der gegebene Bereich und der andere Bereich mittels eines Verfahrens nach einem der Ansprüche 1 bis 9 gebildet wurden.

12. Verfahren zur Herstellung wenigstens eines MOS-Transistors aus einem oder mehreren Halbleiterbereichen, die in einer zur Hauptebene des Trägers parallelen Richtung einen ersten Germaniumkonzentrationsgradienten aufweisen, gebildet mittels eines Verfahrens nach einem der Ansprüche 1 bis 9.

## Claims

1. Method for the realization of a microelectronic device which includes at least one semi-conductor zone (140, 240, 340, 440, 550, 650, 740, 840, 940) which rests on a support and which exhibits, in a direction parallel to the principal plane of the support, a Germanium concentration gradient, the Ge content increasing from centre to the periphery of said semi-conductor zone, the method comprising:
a) The formation on a support of at least one oxidation mask (108, 208) which includes one or more holes (112, 122), where the holes reveal at least one first Si based semi-conductor zone including inclined flanks (121, 122) and having a central portion and a periphery portion, said periphery portion having a thickness smaller than the central portion thickness,
b) The formation of at least one second semi-conductor zone (130, 230) based on Si₁₋ₓGeₓ (where 0 < x) on said first semi-conductor zone so as to protude from the mouth of the holes (112, 114),
- planarizing the second semi-conductor zone so as to reach the level of the oxidation mask (102, 208) then,
c) Thermal oxidation of said first semi-conductor zone and the second semi-conductor zone through said masking layer.

2. Method according to claim 1, wherein said first semi-conductor zone and said second semi-conductor zone form a block with a ratio of Si₁₋ₓGeₓ thickness compared to Si thickness increasing from centre to periphery of said block.

3. Method according to claim 1 or 2, wherein said first semi-conductor zone has inclined flanks oriented according to {11n} (with n≥1).

4. Method according to any of the claims 1 to 3, in which the support (100) is an SOI substrate which includes a support layer, an insulating layer (101) resting on said support layer and a thin semi-conductor layer (102) resting on said insulating layer.

5. Method according to claim 4, in which at step a) the first semi-conductor zone based on Si is formed by growth on the semi-conductor thin layer (102).

6. Method according to claim 4, in which step a) includes:
- The formation of one or more openings in the thin semi-conductor layer,
- The formation of a masking layer which fills in said openings,
- Growth on the thin semi-conductor layer (102) of the first semi-conductor zone.

7. Method according to any of the claims 1 to 6, wherein the method further includes, between step b) and step c): the removal of a thickness of the second semi-conductor zone and of the masking layer, so as to reveal the first semi-conductor zone.

8. Method according to any of the claims 1 to 7, including after step c), the removal of said masking layer and of at least one layer of SiO₂ formed during oxidation.

9. Method according to any of the claims 1 to 8, wherein the second semi-conductor zone based on Si₁₋ₓGeₓ has a Ge concentration of between 5% and 40 %.

10. Method for the realization of at least one vicinal surface on one or more of said semi-conductor zones which exhibits a Germanium concentration gradient in a direction parallel to the principal plane of the support, formed using a method according to any of the claims 1 to 9.

11. Method for the realization of at least one heterojunction formed from at least one given semi-conductor zone exhibiting a first Germanium concentration gradient in a direction parallel to the principal plane of the support, and at least one other semi-conductor next to said given zone and which exhibits a second Germanium concentration in a direction parallel to the principal plane of the support, with said given zone and said other zone having been formed using a method according to any of the claims 1 to 9.

12. Method for the realization of at least one MOS transistor from one or more of said semi-conductor zones which exhibits a first Germanium concentration gradient in a direction parallel to the principal plane of the support, formed using a method according to any of the claims 1 to 9.
